# EUROPÄISCHE PATENTANMELDUNG

(11) **EP 4 178 075 A1**
(43) Veröffentlichungstag der Anmeldung: **10.05.2023**
(21) Anmeldenummer: 22202424.2
(22) Anmeldetag: 19.10.2022
(51) Int. Cl.: H02J 50/12, H02J 50/80

(54) **VERFAHREN ZUM BETREIBEN EINER VORRICHTUNG ZUM DRAHTLOSEN ÜBERTRAGEN VON ENERGIE IN RICHTUNG EINES ELEKTRISCHEN VERBRAUCHERS MITTELS INDUKTIVER KOPPLUNG UND VORRICHTUNG**

(30) Priorität: 08.11.2021 DE 102021212550
(71) Anmelder: E.G.O. Elektro-Gerätebau GmbH, 75038 Oberderdingen (DE)
(72) Erfinder: Bellm, Mathias, 76698 Ubstadt-Weiher (DE); Egenter, Christian, 75015 Bretten (DE); Müller, Max-Felix, 75038 Oberderdingen (DE); Wächter, Ulrich, 76646 Bruchsal (DE)
(74) Vertreter: Patentanwälte Ruff, Wilhelm, Beier, Dauster & Partner mbB

(57) **Zusammenfassung**

Verfahren zum Betreiben einer Vorrichtung zum drahtlosen Übertragen von Energie in Richtung eines elektrischen Verbrauchers mittels induktiver Kopplung, wobei die Vorrichtung aufweist: einen Gleichrichter zum Erzeugen einer Gleichspannung aus einer Netzspannung, einen aus der Gleichspannung gespeisten Wechselrichter, der dazu ausgebildet ist, ein pulsweitenmoduliertes Ansteuersignal zu erzeugen, eine mittels des pulsweitenmodulierten Ansteuersignals angesteuerte Leistungsspule, mittels der zum Übertragen der Energie ein magnetisches Wechselfeld erzeugbar ist, und eine Kommunikationseinrichtung, die dazu ausgebildet ist, Daten bidirektional mit dem elektrischen Verbraucher auszutauschen, wobei das Verfahren die Schritte aufweist: sequenzielles Durchführen einer Leistungsübertragung (LTX), eines Datenaustausches (DAT), einer Messung von Aufstellparametern (MAP) und einer Messung einer Resonanzfrequenz (MRF), wobei während der Leistungsübertragung (LTX) eine von dem Wechselrichter abgegebene elektrischen Ist-Leistung auf einen vorgegebenen elektrischen Sollwert geregelt wird, wobei während des Datenaustausches (DAT) Daten zwischen der Vorrichtung und dem elektrischen Verbraucher mittels der Kommunikationseinrichtung ausgetauscht werden, wobei während der Messung der Aufstellparameter (MAP) über der Leistungsspule gegebenenfalls angeordnete Objekte, insbesondere Fremdobjekte, detektiert werden, wobei während der Messung der Resonanzfrequenz (MRF) eine Resonanzfrequenz eines die Leistungsspule aufweisenden Schwingkreises ermittelt wird, und wobei die Messung der Resonanzfrequenz (MRF) unmittelbar vor oder unmittelbar nach dem Messen der Aufstellparameter (MAP) ausgeführt wird oder unmittelbar vor oder unmittelbar nach dem Datenaustausch (DAT) ausgeführt wird.

## Beschreibung

Der Erfindung liegt die Aufgabe zugrunde, ein Verfahren zum Betreiben einer Vorrichtung zum drahtlosen Übertragen von Energie in Richtung eines elektrischen Verbrauchers mittels induktiver Kopplung und eine entsprechende Vorrichtung zur Verfügung zu stellen, die einen möglichst zuverlässigen Betrieb ermöglichen.

Das Verfahren dient zum Betreiben einer Vorrichtung zum drahtlosen Übertragen von Energie in Richtung eines elektrischen Verbrauchers mittels induktiver Kopplung, auch als Wireless Power Transfer, WPT, bezeichnet. Hinsichtlich der Grundlagen zu WPT sei auch auf die einschlägige Fachliteratur verwiesen. Bevorzugt wird das Verfahren gemäß dem WPC (Wireless Power Consortium) Ki (Cordless Kitchen) Standard betrieben. Die Vorrichtung zum drahtlosen Übertragen von Energie in Richtung eines elektrischen Verbrauchers mittels induktiver Kopplung kann auch als Transmitter bezeichnet werden und der elektrische Verbraucher kann als Receiver bezeichnet werden.

Die Vorrichtung weist einen herkömmlichen einphasigen oder mehrphasigen Gleichrichter zum Erzeugen einer Gleichspannung aus einer insbesondere sinusförmigen Netzspannung auf.

Die Vorrichtung weist einen aus der Gleichspannung gespeisten Wechselrichter auf. Der Wechselrichter kann beispielsweise ein Halbbrücken-Wechselrichter oder ein Vollbrücken-Wechselrichter sein. Der Wechselrichter ist dazu ausgebildet, ein pulsweitenmoduliertes Ansteuersignal mit einstellbarer Frequenz und/oder einstellbarem Tastgrad zu erzeugen.

Die Vorrichtung weist eine herkömmliche mittels des Wechselrichters angesteuerte Leistungsspule oder Transmitterspule auf, die dazu ausgebildet ist, zum Übertragen der Energie ein magnetisches Wechselfeld zu erzeugen. Hierzu wird mittels des Wechselrichters ein, insbesondere periodisches, Ansteuersignal, insbesondere in Form einer Ansteuerspannung, erzeugt und die Leistungsspule oder ein die Leistungsspule aufweisender Schwingkreis wird mit dem Ansteuersignal angesteuert bzw. beaufschlagt. Das Ansteuersignal weist typisch einen von einem Leistungs-Sollwert abhängigen bzw. zu dem Leistungs-Sollwert passenden Arbeitspunkt auf. Ein Arbeitspunkt bezeichnet hierbei insbesondere eine oder mehrere Eigenschaften des Ansteuersignals, beispielsweise Amplitude, Tastgrad und/oder Frequenz des Ansteuersignals.

Die Vorrichtung weist eine Kommunikationseinrichtung auf, die dazu ausgebildet ist, Daten bidirektional mit dem elektrischen Verbraucher auszutauschen.

Das Verfahren weist folgende sequenziell ausgeführten Schritte auf: Durchführen einer Leistungsübertragung mittels der Vorrichtung, Durchführen eines Datenaustausches zwischen der Vorrichtung und dem elektrischen Verbraucher, Durchführen einer Messung von Aufstellparametern mittels der Vorrichtung und Durchführen einer Messung einer Resonanzfrequenz mittels der Vorrichtung. Die Schritte können in immer derselben Reihenfolge ausgeführt werden.

Während der Leistungsübertragung wird eine von dem Wechselrichter abgegebene Leistung auf einen vorgegebenen Sollwert geregelt, wobei als Stellgröße(n) der Regelung beispielsweise eine Frequenz und/oder ein Tastgrad des pulsweitenmodulierten Ansteuersignals dient/dienen.

Während des Datenaustausches werden Daten zwischen der Vorrichtung und dem elektrischen Verbraucher mittels der Kommunikationseinrichtung ausgetauscht, insbesondere gemäß einem NFC Verfahren.

Während der Messung der Aufstellparameter werden über der Leistungsspule gegebenenfalls angeordnete Objekte, insbesondere Fremdobjekte, detektiert. Dies wird auch als Foreign Object Detection (FOD) bezeichnet.

Während der Messung der Resonanzfrequenz wird eine Resonanzfrequenz eines die Leistungsspule aufweisenden Schwingkreises ermittelt. Die Messung der Resonanzfrequenz kann beispielsweise im Wesentlichen wie in der EP 2 330 866 A2 beschrieben erfolgen.

Erfindungsgemäß wird die Messung der Resonanzfrequenz unmittelbar vor oder unmittelbar nach dem Messen der Aufstellparameter ausgeführt und/oder die Messung der Resonanzfrequenz wird unmittelbar vor oder unmittelbar nach dem Datenaustausch ausgeführt.

In einer Ausführungsform wird/werden der Datenaustausch und/oder die Messung der Aufstellparameter in Zeitbereichen durchgeführt, in denen die Netzspannung einen Nulldurchgang aufweist.

In einer Ausführungsform wird das Messen der Resonanzfrequenz in Zeitbereichen durchgeführt, die 0,5 ms bis 2 ms vor einem Nulldurchgang der Netzspannung enden oder in Zeitbereichen durchgeführt, die 0,5 ms bis 2 ms nach einem Nulldurchgang der Netzspannung beginnen.

In einer Ausführungsform wird während des Messens der Resonanzfrequenz der Wechselrichter derart angesteuert, dass die Ansteuerspannung mit einem Erkennen eines Nulldurchgangs bzw. eines Vorzeichenwechsels eines Stroms in die Leistungsspule umgeschaltet, insbesondere um eine entdämpfte Schwingung zu bewirken. Es versteht sich, dass das Erkennen des Nulldurchgangs auch basierend auf einer Stromstärke knapp vor dem Nulldurchgang erfolgen kann, so dass eine Verzögerung der Ansteuerung des Wechselrichters kompensiert werden kann. Die zur Erkennung des Nulldurchgangs verwendete Stromstärke kann dynamisch derart nachgeführt werden, dass der reale Schaltvorgang des Wechselrichters mit dem realen Strom-nulldurchgang zusammenfällt. Die zur Erkennung des Nulldurchgangs verwendete Stromstärke kann beispielsweise in einen entsprechenden Spannungswert gewandelt werden, der einem Komparator als Komparator-Schwelle zugeführt wird.

In einer Ausführungsform wird bei einem Überschreiten einer vorgegebenen Spitzenstromstärke des in die Leistungsspule fließenden Stroms die Messung der Resonanzfrequenz beendet.

In einer Ausführungsform wird basierend auf der ermittelten Resonanzfrequenz mittels der Vorrichtung eine Arbeitsfrequenz ermittelt, mit der die Leistungsspule nachfolgend während der Leistungsübertragung angesteuert wird.

In einer Ausführungsform wird die Arbeitsfrequenz zwischen 0,5 kHz und 3 kHz größer als die Resonanzfrequenz eingestellt.

In einer Ausführungsform überträgt der elektrische Verbraucher arbeitsfrequenzrelevante Informationen zu der Vorrichtung, beispielsweise betreffend seine wirksame elektrische Last-Impedanz. Die Vorrichtung stellt die Arbeitsfrequenz in Abhängigkeit von der Resonanzfrequenz und den arbeitsfrequenzrelevanten Informationen ein. Beispielsweise kann die Differenz zwischen Resonanzfrequenz und Arbeitsfrequenz mit zunehmender wirksame elektrischer Last-Impedanz kleiner eingestellt werden.

Die erfindungsgemäße Vorrichtung zum drahtlosen Übertragen von Energie in Richtung eines elektrischen Verbrauchers mittels induktiver Kopplung ist zur Durchführung eines oben beschriebenen Verfahrens ausgebildet.

Bei den nachfolgenden Erläuterungen wird die Vorrichtung zum drahtlosen Übertragen von Energie in Richtung des elektrischen Verbrauchers mittels induktiver Kopplung als Transmitter bezeichnet und der elektrische Verbraucher wird als Receiver bezeichnet.

Die Erfindung stellt ein Verfahren zum Bestimmen von besonderen Kenn-Arbeitspunkten der Übertragungsfunktion durch den Transmitter zur Verfügung, wobei die Übertragungsfunktion die übertragbare Leistung über der Frequenz beschreibt.

Das Messen der Übertragungsfunktion ist in der Praxis wegen zeitvarianten Verhaltens des Receivers nicht sinnvoll anwendbar. Misst man die Überragungsfunktion beispielsweise mittels eines Frequency Sweeps, dann wird ein Motor abhängig von dem durchlaufenen Frequenzspektrum angeregt und verändert über der Messdauer seine Eigenschaft und somit kann sich auch die Übertragungsfunktion während der Messung ändern.

Das Messen der Übertragungsfunktion hat den Vorteil, dass der Transmitter die maximal übertragbare Leistung für das gesamte Spektrum an Arbeitsfrequenzen kennt. Das erfindungsgemäße Bestimmen der Resonanzfrequenz(en) ist jedoch robuster und erlaubt ebenfalls das Bestimmen von geeigneten Arbeitsfrequenzen sowohl für den Start der Energieübertragung als auch während des Betriebs nach Veränderung der Übertragungsfunktion, beispielsweise aufgrund eines Verschiebens des Receivers, d.h. der Änderung der Kopplung, oder aufgrund einer Laständerung, d.h. einer veränderlichen Motordrehzahl bzw. eines veränderlichen Motormoments, eines Zu- oder Wegschaltens von Lastwiderständen, usw.

Mittels des erfindungsgemäßen Verfahrens kann eine geeignete Arbeitsfrequenz bestimmt werden, die ein sehr schnelles Einregeln der Soll-Leistung ermöglicht. Es versteht sich, dass auch eine zweite, höherfrequente Resonanzfrequenz bestimmt werden kann, die als Basis für die Bestimmung von korrespondierenden Arbeitspunkten mit höherem Übertragungswirkungsgrad verwendet werden kann.

Erfindungsgemäß wird die Messung der Resonanzfrequenz im Wesentlichen direkt nach einer Datenübertragung bzw. einer Messung der Aufstellparameter (Foreign Object Detection, FOD) durchgeführt. Die Datenübertragung bzw. die Messung der Aufstellparameter erfolgt im aktiven Betrieb jeweils +/- 1ms um alle Netznulldurchgänge, solange der Betrag der Netzspannung noch relativ gering ist und somit trotz Resonanzbetriebs der resultierende Strom nicht zu groß wird. Alternativ denkbar ist eine Messung der Resonanzfrequenz direkt vor der Datenübertragung bzw. direkt vor der Messung der Aufstellparameter.

Bei der kabellosen Leistungsübertragung variiert die Impedanz und Resonanzfrequenz abhängig von dem aufgestellten Receiver deutlich, es können sogar Doppel-Peaks in der Übertragungsfunktion auftreten. Trotzdem ist ein schnelles Einregeln der Leistung notwendig, um beispielsweise ein Verschieben des Receivers oder eine Laständerung abzufangen und den Receiver in seinem Betriebsverhalten stabil zu halten.

Eine von dem Wechselrichter abgegebene elektrische Ist-Leistung kann auf eine vorgebbare elektrische Soll-Leistung geregelt werden, wobei als Stellgrößen der Regelung eine Frequenz und ein Tastgrad des pulsweitenmodulierten Ansteuersignals dienen. Zum Einregeln auf die Soll-Leistung werden folgende Schritte durchgeführt: a) Einstellen einer Start-Frequenz, b) Einstellen eines Start-Tastgrads derart, dass die Soll-Leistung unterschritten wird, c) Messen einer durch den Wechselrichter abgegebenen elektrischen Ist-Leistung bei der eingestellten Start-Frequenz und dem eingestellten Start-Tastgrad, d) Wählen einer Einregel-Soll-Leistung, die kleiner als oder gleich wie die Soll-Leistung ist, e) Berechnen eines Tastgrads, der der Einregel-Soll-Leistung rechnerisch entspricht, f) Einstellen des berechneten Tastgrads, g) Messen einer durch den Wechselrichter abgegebenen elektrischen Ist-Leistung bei der eingestellten Frequenz und dem eingestellten Tastgrad, und h) Wiederholen der Schritte d) bis g) bei zunehmender Einregel-Soll-Leistung so lange, bis eine Abweichung zwischen der Soll-Leistung und der Ist-Leistung eine vorgegebene Schwelle unterschreitet.

Mittels des erfindungsgemäßen Verfahrens kann die oben beschriebene Start-Frequenz basierend auf der Messung der Resonanzfrequenz einfach ermittelt werden.

Es kann eine höherfrequente Resonanzfrequenz bestimmt werden, um die herum korrespondierende Arbeitspunkte mit gleichem Leistungsniveau liegen können, die einen höheren Übertragungswirkungsgrad besitzen können. Hierfür wird die Messung der Resonanzfrequenz mit einer hohen Frequenz gestartet und die Änderungsgeschwindigkeit der Frequenzregelung muss begrenzt werden, auf beispielsweise < 2 kHz.

Das erfindungsgemäße Verfahren dient zum Bestimmen einer Resonanzfrequenz für einen Wechselrichter in Halb- oder Vollbrückentechnologie zur Energieübertragung an einen kabellosen Verbraucher. Bei der Ermittlung der Resonanzfrequenz sind die Ausgangsspannung des Wechselrichters sowie der Strom in die Leistungsspule bzw. Transmitterspule zumindest am Ende einer Messung in etwa in Phase (Phasenwinkel zwischen Spannung und Strom <+/-20°, bevorzugt <+/-5), d.h. das Schalten der Schaltmittel des Wechselrichters erfolgt beim Strom-nulldurchgang des Leistungsspulenstroms.

Die Leistungsübertragung vom Transmitter zum Receiver wird periodisch unterbrochen (Slotted Mode), wobei die Unterbrechungen bevorzugt um einen Nulldurchgang der Netzspannung herum erfolgen. Die Unterbrechungen (Slots) können zur Kommunikation zwischen Transmitter und Receiver und/oder für Messungen, beispielsweise dem Erkennen von unzulässigen Fremdmetall-Objekten (Foreign Object Detection, FOD), verwendet werden.

Die Messung der Resonanzfrequenz findet bevorzugt direkt vor oder direkt nach dem Ende der Datenübertragung bzw. des Kommunikations-Slots statt (bei Ki WPT üblich 1ms nach Netznulldurchgang, kann je nach Betriebsmodus davon abweichen).

Die Messung der Resonanzfrequenz dauert typisch nicht länger als 0,5ms, vorzugsweise nicht länger als 0,2ms.

Die Datenübertragung bzw. die Kommunikations-Slots findet/finden um den Nulldurchgang der Netzspannung herum statt.

Die Messung der Resonanzfrequenz wird bevorzugt bei einem Überschreiten eines Maximalstroms abgebrochen.

Die Messung der Resonanzfrequenz wird bevorzugt beendet, wenn sich die gemessene Frequenz nicht mehr signifikant ändert, d.h. beispielsweise die Frequenzänderung zwischen zwei Perioden < 1 kHz, bevorzugt < 0,5 kHz ist.

Es kann eine Stromhöhe bei Resonanz sowie die zugehörige Spannung bestimmt werden und basierend darauf die mögliche übertragbare Leistung im Resonanzbetrieb abgeschätzt werden.

Es kann eine Arbeitsfrequenz für die Leistungsübertragung berechnet werden, indem ein Delta-f zu der gemessenen Resonanzfrequenz addiert wird, wobei Delta-f maximal 5 kHz, bevorzugt maximal 2 kHz beträgt. Delta_f kann abhängig von der abgeschätzten Leistung im Resonanzbetrieb und/oder einem kommunizierten Parameter des Receivers variiert werden.

Bevorzugt wird der Wechselrichter mit der neuen Arbeitsfrequenz unmittelbar nach der Messung der Resonanzfrequenz betrieben, zumindest noch in der Netzhalbwelle der Netzspannung direkt auf den Kommunikations-Slot folgend, bevorzugt zumindest 1,5 ms vor dem Erreichen des Netzspannungsmaximums der Netzspannung.

Bevorzugt wird der Wechselrichter mit der Arbeitsfrequenz in der ersten Halbwelle der Netzspannung vorteilhaft mit einem Tastverhältnis < 30 % für die Leistungsübertragung angesteuert.

Bevorzugt wird beim Start der Leistungsübertragung mit dem Umschalten von der Datenübertragung auf die Leistungsübertragung die Messung der Resonanzfrequenz durchgeführt und eine erste Resonanzfrequenz bestimmt. Bevorzugt wird eine neue Messung der Resonanzfrequenz durchgeführt, wenn die gemessene Ist-Leistung einer Netzhalbwelle der Netzspannung zumindest 20%, insbesondere zumindest 10%, unter der Soll-Leistung für die nächste Netzhalbwelle liegt und der Tastgrad bereits größer als 40% ist. Ein Trigger für ein neues Bestimmen einer Arbeitsfrequenz ist bevorzugt eine relevante Unterleistung, die sowohl durch ein Absinken der Ist-Leistung wegen Änderung der Übertragungsfunktion als auch durch einen Soll-Leistungssprung ausgelöst werden kann. Positive Abweichungen können sofort mittels Tastgrad korrigiert werden, kleine negative Abweichungen können durch ein Reduzieren der Arbeitsfrequenz um wenige 100 Hz ausgeglichen werden.

Die Messung der Resonanzfrequenz kann mit einer gesteuerten Ein-Dauer eines oder beider Schaltmittel einer Halbbrücke des Wechselrichters gestartet werden. Eine erste Ein-Dauer kann einer halben Periodendauer einer untersten Arbeitsfrequenz entsprechen.

Die Messung der Resonanzfrequenz kann mit einer vorbestimmten, hohen Ansteuerfrequenz des Wechselrichters gestartet werden, wobei die Änderung der Ansteuerfrequenz auf kleiner +/-5 kHz, bevorzugt +/- 2kHz begrenzt wird, damit ein lokales Maximum bei höheren Frequenzen gefunden werden kann.

Eine Abweichung der Ist-Leistung kann durch das Integrieren einer Messung der Resonanzfrequenz während einer Leistungsübertragung zum Verbraucher erkannt werden und in der nächsten oder übernächsten Netzhalbwelle der Netzspannung zeitnah kompensiert werden, damit die mittlere Leistung des Receivers konstant bleibt.

Die Messung der Resonanzfrequenz kann erfindungsgemäß vollständig im Transmitter unabhängig vom Receiver durchgeführt werden. Lediglich für die Bestimmung eines geeigneten Delta_f können optional vom Receiver kommunizierte Parameter verwendet werden.

Die Übertragungsfunktion ist abhängig von der Kopplung zwischen Receiver und Transmitter und der Last im Receiver. Die übertragene Leistung an einem bestimmten Arbeitspunkt kann sich folglich ändern, wenn der Receiver die Last umschaltet, z.B. von einem Motor zu einer Heizung, wenn der Receiver verschoben wird und sich die Kopplung ändert, oder aufgrund einer Laständerung wie beispielsweise der Zugabe von Lebensmitteln in einen Mixer, was eine Drehmomentänderung am Motor bewirkt. Eine Änderung der Übertragungsfunktion kann grundsätzlich durch eine veränderte Leistung bei sonst gleichbleibendem Arbeitspunkt (Frequenz und Tastverhältnis) festgestellt werden. Tritt eine Änderung der Übertragungsfunktion auf, so muss schnellstmöglich die geforderte Soll-Leistung eingestellt werden.

Eine Leistungsreduzierung kann sofort über das Tastverhältnis erfolgen. Eine Erhöhung der abgegebenen Leistung ist bei gleichbleibender Arbeitsfrequenz nur dann und nur in geringem Maße möglich, wenn das Tastverhältnis noch < 50 % ist. Sonst muss die Arbeitsfrequenz geändert werden. Je nach Kopplung und Last kann die Leistungsdifferenz bei veränderter Frequenz dP/df sehr groß sein, die Rede ist dann von einer steilen Übertragungsfunktion. Zusätzlich sind eventuell vorherig gespeicherte Arbeitspunkte nicht mehr gültig, da sich die Übertragungsfunktion stark geändert hat. Im Extremfall kann sogar dP/df das Vorzeichen wechseln, d.h. eine Frequenzänderung, die mit der vorherigen Übertragungsfunktion die Leistungsdifferenz reduziert hätte, könnte eine größere Leistungsabweichung zur Folge haben.

Anstatt sich langsam an eine geeignete Frequenz heranzutasten wird erfindungsgemäß sofort eine Startfrequenz vorgegeben, an der jede geforderte Leistung bis mindestens zur Nominalleistung möglich ist. Dasselbe Prinzip wird zum erstmaligen Finden des Startarbeitspunkts genutzt.

Erfindungsgemäß findet dazu die Messung der Resonanzfrequenz statt. Die Resonanzfrequenz ist hierbei nicht zwangsläufig die Frequenz, an der die maximale Leistung übertragen werden kann, sondern die Frequenz, an der der Phasenwinkel zwischen Strom und Spannung 0° beträgt. So ergibt sich ein stromfreies Schalten der IGBTs, was vorteilhaft ist. Die Frequenz, an der die maximale Leistung übertragen werden würde, liegt zumeist im kapazitiven Frequenzbereich, der nachteilig für den Betrieb der Induktion ist. Die erreichbare Leistung im Leistungsmaximum ist weiterhin erheblich zu groß, d.h. die Anforderungen an die Auflösung im Tastverhältnis steigen. In der Resonanzfrequenz ist die erreichbare Leistung immer noch größer als die Nominalleistung, so dass dieser Arbeitspunkt bevorzugt wird.

Die Erzeugung des Ansteuersignals des Wechselrichters für die Messung kann in Hardware und/oder in Software implementiert sein. Ein Komparator kann beispielsweise das Ansteuersignal für die Treiber der IGBTs des Wechselrichters erzeugen. Je nachdem, ob der Strom durch die Leistungsspule positiv oder negativ ist, wird ein High- bzw. Low-Pegel ausgegeben. So wird immer im Strom-Nulldurchgang geschaltet und ein Phasenwinkel von nahe 0° erreicht. Soll ein Phasenwinkel von exakt 0° erreicht werden, muss bei einer Stromstärke etwas vor dem Nulldurchgang geschaltet werden, wobei die Dauer bis zum Nulldurchgang dann der Ansteuerverzögerung durch Komparator, Treiber und IGBT entspricht. Die tatsächliche Frequenz kann dann gemessen werden, beispielsweise durch Messen der Periodendauer.

Eine Erzeugung des Signals in Software hat den Vorteil, dass die Frequenz sofort bekannt ist. Zusätzlich lassen sich in Software Totzeiten für der IGBTs und Totzeiten des Treibers kompensieren, so dass die Resonanz besser getroffen und die Frequenz genauer bestimmt werden kann.

Je nach Restladung der Schwingkreiskondensatoren und des Zwischenkreiskondensators kann es sein, dass es nicht von allein zu einem Strom durch die Leistungsspule kommt und daher die Messung nicht startet. Um dieses Verhalten zu verhindern, kann vor der Umschaltung auf die Komparator-basierte Ansteuerung des Wechselrichters eine Ansteuerung für wenige, vorzugsweise eine oder sogar nur eine halbe, PWM-Periode erfolgen, die ausreichend ist, um den Komparator erstmalig zu schalten und die resonante Schwingung einzuleiten.

Aufgrund der hohen Maximalleistung (50 % Tastgrad) an der Resonanzfrequenz ist hier eine hochdynamische Regelung der Leistung möglich. Es kann einfach das erforderliche Tastverhältnis für eine vorgegebene Soll-Leistung berechnet werden und innerhalb weniger Regelschritte der Arbeitspunkt eingestellt werden. Ist die Soll-Leistung erreicht, kann danach langsam die Arbeitsfrequenz optimiert werden, beispielsweise derart, dass die Effizienz erhöht, eine Frequenzsynchronisation zwischen Koch- und Ki-Stellen ermöglicht oder die EMV verbessert wird.

Die Maximalleistung an der gemessenen Resonanzfrequenz ist höher als die Nominalleistung, üblicherweise auch höher als die erforderliche Leistung zur Kompensation der Verluste durch Kopplung etc. Um die Leistung feiner Regeln zu können, ist es vorteilhaft, leicht oberhalb dieser Resonanzfrequenz zu arbeiten.

Dazu wird ein Offset auf die gemessene Resonanzfrequenz addiert. Dieser Offset ist abhängig von der Steilheit dP/df an der Resonanzfrequenz und kann über den Faktor QPRx oder Kombination aus Receiver-Induktivität und Lastwiderstand abgeschätzt werden. Wird der Faktor nicht vom Receiver übertragen, kann ein fester Wert als Offset addiert werden, beispielsweise 2 kHz. Alternativ kann auch direkt mit der Resonanzfrequenz, also mit einem Offset von 0 Hz gearbeitet werden.

Die übertragene Leistung während der Messung hängt vom Receiver und der vorhandenen Ladung im Zwischenkreis sowie den Schwingkreiskondensatoren ab. Eine kurze Messdauer von 0,2 ms bis 0,5 ms reduziert die übertragene Leistung. Für eine eventuelle Kompensation ist es vorteilhaft, die Leistung während der Messung der Resonanzfrequenz mit aufzunehmen. Trotz der kurzen Dauer kann eine nicht unerhebliche Leistung übertragen werden, da in der Resonanzfrequenz gearbeitet wird.

Grundsätzlich ist die Messung der Resonanzfrequenz sicher, obwohl in der Resonanz gemessen wird, weil einerseits die Dauer der Messung kurz gehalten wird und bereits durch die Datenübertragung in Form der NFC-Kommunikation das Vorhandensein eines Receivers, und damit einer Last, bestätigt wurde.

Die Receiver enthalten allerdings ein Schaltmittel zum Unterbrechen des Receiver-Stromkreises im Fehlerfall und als Schutzmechanismus. Ist dieser Schalter nicht geschlossen, so sieht der Transmitter keine Last und der Betrieb oder die Messung an der Resonanzfrequenz wäre ungünstig. Dagegen wird eine schnelle Abschaltung bei Überstrom eingesetzt. Bestenfalls wird mit einem Komparator die Stromgrenze überwacht und beim Überschreiten eines Maximalstroms die Messung sofort abgebrochen. Alternativ kann auch bei einer gewissen Leistung abgebrochen werden.

Die Messung kann frühzeitig beendet werden, sobald die Resonanzfrequenz erkannt wurde.

Die Gesamtmessdauer der Messung der Resonanzfrequenz soll kurz sein, damit eine Messung im laufenden Betrieb ohne signifikante Erhöhung (bei kleiner Soll-Leistung) oder Reduzierung (bei großer Soll-Leistung) der übertragenen Leistung erfolgen kann. Praktisch ist die Leistung in der Resonanzfrequenz immer größer als jede Soll-Leistung, d.h. es muss nur eine Erhöhung vermieden werden.

Die Messung zu Beginn der Netzhalbwelle der Netzspannung findet in einem Zeitraum statt, in dem die übertragenen Leistung nur ein Bruchteil der Leistung der gesamten Netzhalbwelle beträgt. Aufgrund P~U² wird der Großteil der Leistung im Netzspannungsmaximum übertragen, so dass zu Beginn der Netzhalbwelle der Einfluss der Messung gering bleibt.

Eine Abweichung zur Soll-Leistung kann in der nächsten oder übernächster AC-Halbwelle entsprechend korrigiert werden, damit die mittlere Leistung des Receivers konstant bleibt.

Eine Messung muss vor dem Start der Regelung der übertragenen Leistung durchgeführt werden, kann aber auch im Betrieb wiederholt werden, um Änderungen der Übertragungsfunktion durch Verschieben des Receivers oder einer Laständerung festzustellen.

Bevor die Messung der Resonanzfrequenz stattfinden kann, muss das System ausreichend eingeschwungen sein, d.h. die Messung der nachfolgenden Periode mit gleicher Frequenz sollte nur in einem akzeptablen Bereich abweichen. Das Einschwingen muss sowohl zum Start der Messung vor Starten der Leistungsübertragung als auch beim Umstellen der Arbeitsfrequenz aus dem Betrieb der Leistungsübertragung zum Messbetrieb beachtet werden.

Beim Umschalten von Schwingungsanregung auf Messbetrieb und vom Messbetrieb zum normalen Betrieb ist zu beachten, dass die Frequenzen harmonisch übergehen, d.h. die Umschaltung zu den aktuellen Schaltzeitpunkten synchronisiert wird, um zusätzliche Verzögerungen für das Einschwingen sowie eine Geräuschentwicklung durch Oberwellen weitgehend zu vermeiden.

Beim Transmitter wird aus Kostengründen nur ein relativer kleiner Energiespeicher im Zwischenkreis vorgesehen. Wird während der vorhergehenden Netzhalbwelle viel Leistung übertragen, so ist die Spannung für die nächste Startfrequenzmessung klein.

Nichtlinearitäten über der Auslenkung, also Strom, spielen für die Messung keine Rolle, da sie sich stark auf die übertragene Leistung, aber nur sehr geringfügig bis gar nicht auf die Frequenz auswirken. Eventuelle Fehler sind unkritisch, da an dem Arbeitspunkt ohnehin eine Leistung größer der Nominalleistung erreicht werden kann, d.h. es ergibt sich eine Art Toleranzband in dem mögliche Startfrequenzen zur Suche der eigentlichen Arbeitsfrequenz liegen.

Die Messung der Resonanzfrequenz wird nicht in jeder Netzhalbwelle durchgeführt. Grundsätzlich wird sie immer nur dann benötigt, wenn die Übertragungsfunktion unbekannt ist. Das ist z.B. dann der Fall, wenn ganz zu Beginn die Last-Impedanz und die Aufstellposition, also die Kopplung, unbekannt sind, sich die Aufstellposition des Receivers, also die Kopplung, verändert hat, und sich die Last im Receiver geändert hat, sei es durch ein geplantes Umschalten von unterschiedlichen Lasten durch die Receiver-Steuerung oder ungeplant, beispielsweise durch eine sich ändernde Last am Motor wie in einem Mixer, oder falls eine deutlich höhere Soll-Leistung bei gleichbleibender Last-Impedanz angefordert wird, so dass eine Frequenzänderung über mehrere 5 kHz notwendig ist.

Die Erfindung wird nachfolgend unter Bezugnahme auf die Zeichnungen detailliert beschrieben. Hierbei zeigt:
- Fig. 1: ein Blockschaltbild einer Vorrichtung zum drahtlosen Übertragen von Energie und einen zugehörigen elektrischen Verbraucher,
- Fig. 2: einen prinzipiellen zeitlichen Ablauf des erfindungsgemäßen Verfahrens, und
- Fig. 3: einen zeitlichen Verlauf eines Stroms in eine Leistungsspule während einer Halbwelle einer Netzspannung.

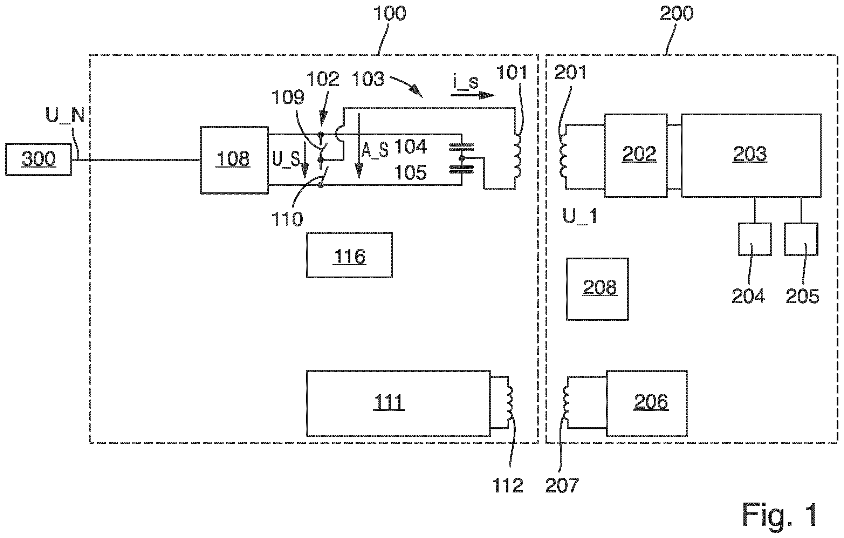

Fig. 1 zeigt ein Blockschaltbild einer Vorrichtung 100 zum drahtlosen Übertragen von Energie in Richtung eines elektrischen Verbrauchers 200 mittels induktiver Kopplung.

Die Vorrichtung 100 weist einen Gleichrichter 108 zum Erzeugen einer Gleichspannung U_S aus einer herkömmlichen einphasigen Netzspannung U_N eines Wechselspannungsnetzes 300 auf.

Die Vorrichtung 100 weist weiter einen aus der Gleichspannung U_S gespeisten Wechselrichter 102 mit Schaltmitteln 109 und 110 auf, der dazu ausgebildet ist, ein pulsweitenmoduliertes Ansteuersignal A_S zu erzeugen.

Die Vorrichtung 100 weist weiter Kondensatoren 104, 105 auf, die in Serie zwischen Ausgangsanschlüsse des Gleichrichters 108 bzw. die Speisespannung U_S eingeschleift sind.

Die Vorrichtung 100 weist weiter eine mittels des pulsweitenmodulierten Ansteuersignals A_S angesteuerte Leistungsspule 101 auf, wobei die Kondensatoren 104, 105 und die Leistungsspule 101 derart verschaltet sind, dass sie einen Schwingkreis 103 bilden. Hierzu ist ein Anschluss der Leistungsspule 101 mit einem Verbindungsknoten von Halbleiterschaltmitteln 109, 110 des Wechselrichters 102 elektrisch verbunden und ein anderer Anschluss der Leistungsspule 101 ist mit einem Verbindungsknoten der Kondensatoren 104, 105 elektrisch verbunden.

Es versteht sich, dass die dargestellte Wechselrichter- und Schwingkreistopologie lediglich exemplarisch ist. Es kann im Rahmen der vorliegenden Erfindung beispielsweise ein Wechselrichter mit einer Vollbrücke verwendet werden, es können anders verschaltete Serien- oder Parallelschwingkreise verwendet werden, usw.

Mittels der Leistungsspule 101 wird zum Übertragen der Energie ein magnetisches Wechselfeld erzeugt.

Die Vorrichtung 100 weist weiter eine Kommunikationseinrichtung 111 auf, die mit einer Kommunikationsspule 112 gekoppelt ist. Die Kommunikationseinrichtung 111 in Verbindung mit der Kommunikationsspule 112 dient zum bidirektionalen Datenaustausch mit dem elektrischen Verbraucher 200.

Die Vorrichtung 100 weist weiter einen Regler 116 auf, der dazu ausgebildet ist, eine von dem Wechselrichter 102 abgegebene Leistung auf einen vorgebbaren Sollwert zu regeln, wobei als Stellgröße eine Frequenz und/oder ein Tastgrad des Ansteuersignals A_S dient/dienen.

Der elektrische Verbraucher 200 weist eine Leistungsspule 201 und einen nachgeschalteten passiven LC-Resonanzkreis 202 auf.

Der elektrische Verbraucher 200 weist weiter eine Schalteinrichtung 203 zur Veränderung einer Last-Impedanz des elektrischen Verbrauchers 200 auf. Als zu- bzw. abschaltbare Lasten sind exemplarisch die Elemente 204 und 205 dargestellt.

Der elektrische Verbraucher 200 weist weiter eine Kommunikationseinrichtung 206 auf, die mit einer Kommunikationsspule 207 gekoppelt ist. Die Kommunikationseinrichtung 206 in Verbindung mit der Kommunikationsspule 207 dient zum bidirektionalen Datenaustausch mit der Vorrichtung 100.

Der elektrische Verbraucher 200 weist weiter eine Steuereinrichtung 208 auf, die den Betrieb des elektrischen Verbrauchers 200 steuert. Die Steuereinrichtung 208 steht in Datenverbindung mit der Schalteinrichtung 203 und der Kommunikationseinrichtung 206. Die Steuereinrichtung 208 steuert unter anderem das synchronisierte Verändern der Last-Impedanz durch geeignete Ansteuerung der Schalteinrichtung 203 und Kommunikation mit der Vorrichtung 100.

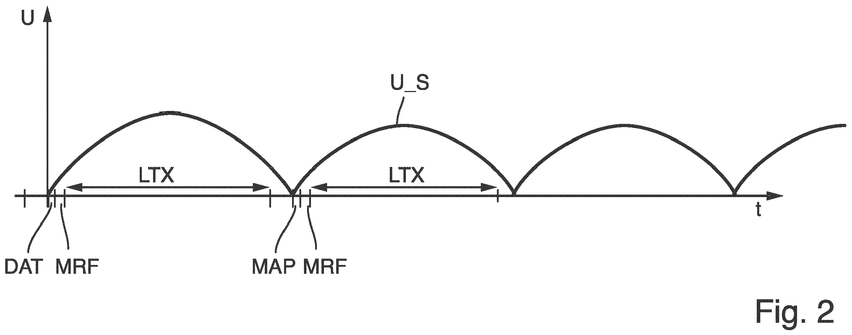

Fig. 2 zeigt einen prinzipiellen Ablauf des erfindungsgemäßen Verfahrens über der Zeit.

Wie in Fig. 2 dargestellt, weist die Gleichspannung U_S einen Halbwellen-förmigen Verlauf auf, der im Wesentlichen gleichgerichteten Netzhalbwellen der Netzspannung U_N entspricht.

In Zeitbereichen bzw. Slots, in denen die Netzspannung U_N einen Nulldurchgang aufweist, erfolgt entweder ein Datenaustausch DAT zwischen Vorrichtung 100 und Verbraucher 200 oder eine Messung von Aufstellparametern MAP, auch als Foreign Object Detection, FOD, bezeichnet. Dazwischen erfolgt in zugehörigen Zeitbereichen bzw. Slots herkömmlich eine Leistungsübertragung LTX.

Eine Messung der Resonanzfrequenz MRF des die Leistungsspule 101 aufweisenden Schwingkreises 103 erfolgt unmittelbar vor oder unmittelbar nach dem Messen der Aufstellparameter MAP oder unmittelbar vor oder unmittelbar nach dem Datenaustausch DAT. Anders als in Fig. 2 zu Illustrationszwecken dargestellt, erfolgt die Messung der Resonanzfrequenz MRF in der Praxis nicht regelmäßig nach der Datenübertragung DAT bzw. dem Messen der Aufstellparameter MAP. Stattdessen erfolgt die Messung der Resonanzfrequenz MRF zum Beginn des drahtlosen Übertragens von Energie in Richtung des elektrischen Verbrauchers 200 und anschließend bei relevanten Änderungen der Leistungsübertragung. Relevante Änderungen können größere Soll-Leistungssprünge, Verschieben des Verbrauchers 200 mit einer Kopplungsänderung sowie angekündigte Lastsprünge des Receivers 200 darstellen, die ein neues Bestimmen des Arbeitsfrequenz erfordern.

Das Messen der Resonanzfrequenz MRF erfolgt in Zeitbereichen, die 0,5 ms bis 2 ms vor einem Nulldurchgang der Netzspannung U_N enden oder in Zeitbereichen, die 0,5 ms bis 2 ms nach einem Nulldurchgang der Netzspannung U_N beginnen, wie in Fig. 2 dargestellt.

Während des Messens der Resonanzfrequenz MFR wird der Wechselrichter 102 derart angesteuert, dass die Ansteuerspannung A_S mit einem Erkennen eines Nulldurchgangs eines Stroms i_s in die Leistungsspule 101 umgeschaltet wird.

Basierend auf der ermittelten Resonanzfrequenz wird unmittelbar anschließend eine Arbeitsfrequenz eingestellt, mit der die Leistungsspule 101 unmittelbar nachfolgend während der Leistungsübertragung LTX angesteuert wird. Die Arbeitsfrequenz wird beispielsweise zwischen 0,5 kHz und 3 kHz kleiner als die Resonanzfrequenz eingestellt. Weiter kann der elektrische Verbraucher 200 arbeitsfrequenzrelevante Informationen zu der Vorrichtung 100 übertragen, wobei die Arbeitsfrequenz in Abhängigkeit von der Resonanzfrequenz und den arbeitsfrequenzrelevanten Informationen eingestellt wird.

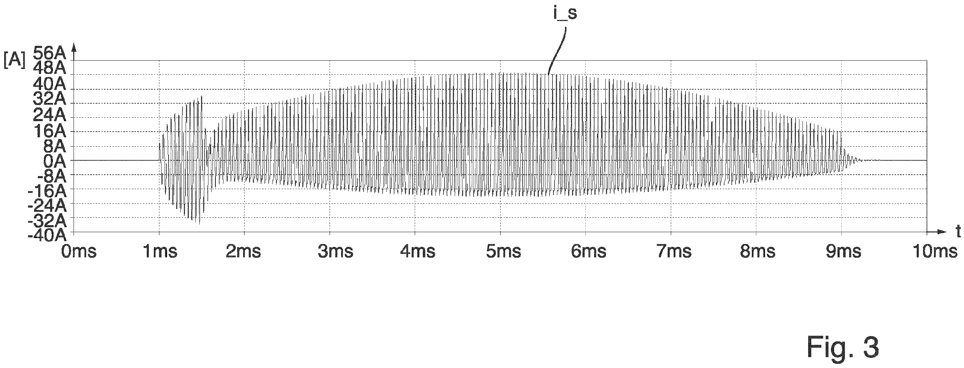

Fig. 3 zeigt einen zeitlichen Verlauf des Stroms i_s in die Leistungsspule 101 während einer Halbwelle der Netzspannung UN mit 50 Hz.

In einem Slot zwischen 0 ms und 1 ms erfolgt ein Datenaustausch DAT zwischen der Vorrichtung 100 und dem Verbraucher 200 über deren Kommunikationsspulen 112 bzw. 207.

In einem Slot zwischen 1 ms und 1,5 ms erfolgt die Messung der Resonanzfrequenz MRF.

In einem Slot zwischen 1,5 ms und 9 ms kurz vor dem Ende der Netzhalbwelle erfolgt die Leistungsübertragung LTX mit einer Arbeitsfrequenz, die in Abhängigkeit von der gemessenen Resonanzfrequenz eingestellt wird.

Bei 9ms wird die Leistungsüberragung unterbrochen und der nächste Slot für eine nächste Datenübertragung oder zum Messen von Aufstellparametern startet.

## Patentansprüche

1. Verfahren zum Betreiben einer Vorrichtung (100) zum drahtlosen Übertragen von Energie in Richtung eines elektrischen Verbrauchers (200) mittels induktiver Kopplung, wobei die Vorrichtung aufweist:
- einen Gleichrichter (108) zum Erzeugen einer Gleichspannung (U_S) aus einer Netzspannung (U_N),
- einen aus der Gleichspannung (U_S) gespeisten Wechselrichter (102), der dazu ausgebildet ist, ein pulsweitenmoduliertes Ansteuersignal (A_S) zu erzeugen,
- eine mittels des pulsweitenmodulierten Ansteuersignals (A_S) angesteuerte Leistungsspule (101), mittels der zum Übertragen der Energie ein magnetisches Wechselfeld erzeugbar ist, und
- eine Kommunikationseinrichtung (111), die dazu ausgebildet ist, Daten bidirektional mit dem elektrischen Verbraucher (200) auszutauschen,
wobei das Verfahren die Schritte aufweist:
- sequenzielles Durchführen einer Leistungsübertragung (LTX), eines Datenaustausches (DAT), einer Messung von Aufstellparametern (MAP) und einer Messung einer Resonanzfrequenz (MRF),
- wobei während der Leistungsübertragung (LTX) eine von dem Wechselrichter (102) abgegebene elektrischen Ist-Leistung auf einen vorgegebenen elektrischen Sollwert geregelt wird,
- wobei während des Datenaustausches (DAT) Daten zwischen der Vorrichtung (100) und dem elektrischen Verbraucher (200) mittels der Kommunikationseinrichtung (111) ausgetauscht werden,
- wobei während der Messung der Aufstellparameter (MAP) über der Leistungsspule (101) gegebenenfalls angeordnete Objekte, insbesondere Fremdobjekte, detektiert werden,
- wobei während der Messung der Resonanzfrequenz (MRF) eine Resonanzfrequenz eines die Leistungsspule (101) aufweisenden Schwingkreises (103) ermittelt wird, und
- wobei die Messung der Resonanzfrequenz (MRF) unmittelbar vor oder unmittelbar nach dem Messen der Aufstellparameter (MAP) ausgeführt wird oder unmittelbar vor oder unmittelbar nach dem Datenaustausch (DAT) ausgeführt wird.

2. Verfahren nach Anspruch 1, **dadurch gekennzeichnet, dass**
- der Datenaustausch (DAT) und/oder die Messung der Aufstellparameter (MAP) in Zeitbereichen durchgeführt wird/werden, in denen die Netzspannung (U_N) einen Nulldurchgang aufweist.

3. Verfahren nach einem der vorhergehenden Ansprüche, **dadurch gekennzeichnet, dass**
- das Messen der Resonanzfrequenz (MRF) in Zeitbereichen durchgeführt wird, die 0,5 ms bis 2 ms vor einem Nulldurchgang der Netzspannung (U_N) enden oder in Zeitbereichen durchgeführt wird, die 0,5 ms bis 2 ms nach einem Nulldurchgang der Netzspannung (U_N) beginnen.

4. Verfahren nach einem der vorhergehenden Ansprüche, **dadurch gekennzeichnet, dass**
- während des Messens der Resonanzfrequenz (MFR) der Wechselrichter (102) derart angesteuert wird, dass die Ansteuerspannung (A_S) mit einem Erkennen eines Nulldurchgangs eines Stroms (i_s) in die Leistungsspule (101) umgeschaltet wird.

5. Verfahren nach Anspruch 4, **dadurch gekennzeichnet, dass**
- bei einem Überschreiten einer vorgegebenen Spitzenstromstärke des in die Leistungsspule (101) fließenden Stroms (i_s) die Messung der Resonanzfrequenz (MRF) beendet wird.

6. Verfahren nach einem der vorhergehenden Ansprüche, **dadurch gekennzeichnet, dass**
- basierend auf der ermittelten Resonanzfrequenz eine Arbeitsfrequenz ermittelt wird, mit der die Leistungsspule (101) nachfolgend während der Leistungsübertragung (LTX) angesteuert wird.

7. Verfahren nach Anspruch 6, **dadurch gekennzeichnet, dass**
- die Arbeitsfrequenz zwischen 0,5 kHz und 3 kHz größer als die Resonanzfrequenz eingestellt wird.

8. Verfahren nach Anspruch 6 oder 7, **dadurch gekennzeichnet, dass**
- der elektrische Verbraucher (200) arbeitsfrequenzrelevante Informationen zu der Vorrichtung (100) übertragt, wobei die Arbeitsfrequenz in Abhängigkeit von der Resonanzfrequenz und den arbeitsfrequenzrelevanten Informationen eingestellt wird.

9. Vorrichtung (100) zum drahtlosen Übertragen von Energie in Richtung eines elektrischen Verbrauchers (200) mittels induktiver Kopplung, wobei die Vorrichtung aufweist:
- einen Gleichrichter (108) zum Erzeugen einer Gleichspannung (U_S) aus einer Netzspannung (U_N),
- einen aus der Gleichspannung (U_S) gespeisten Wechselrichter (102), der dazu ausgebildet ist, ein pulsweitenmoduliertes Ansteuersignal (A_S) zu erzeugen,
- eine mittels des pulsweitenmodulierten Ansteuersignals (A_S) angesteuerte Leistungsspule (101), mittels der zum Übertragen der Energie ein magnetisches Wechselfeld erzeugbar ist, und
- eine Kommunikationseinrichtung (111), die dazu ausgebildet ist, Daten bidirektional mit dem elektrischen Verbraucher (200) auszutauschen,
**dadurch gekennzeichnet, dass**
- die Vorrichtung zur Durchführung eines Verfahrens nach einem der vorhergehenden Ansprüche ausgebildet ist.
